# EUROPÄISCHE PATENTSCHRIFT

(11) **EP 2 270 528 B1**
(45) Veröffentlichungstag und Bekanntmachung des Hinweises auf die Patenterteilung: **30.06.2021**
(21) Anmeldenummer: 10161033.5
(22) Anmeldetag: 26.04.2010
(51) Int. Cl.: G01R 31/36

(54) **Batteriestatusanzeige in Verbindung mit Anzeige der Restlaufzeit**
Battery status display in connection with display of remaining time
Affichage de l'état d'une batterie en liaison avec l'affichage du temps de marche restant

(30) Priorität: 03.07.2009 DE 102009031828
(43) Veröffentlichungstag der Anmeldung: 05.01.2011
(73) Patentinhaber: Vodafone Holding GmbH, 40213 Düsseldorf (DE)
(72) Erfinder: Famulla, Frank, 40589 Düsseldorf (DE)
(74) Vertreter: Weisbrodt, Bernd

(56) Entgegenhaltungen:
- WO-A1-2008/101251
- DE-A1- 10 345 437
- US-A1- 2003 158 609
- US-A1- 2009 164 152

## Beschreibung

### Technisches Gebiet

Die Erfindung betrifft eine Anzeigevorrichtung zum Darstellen eines Batterieladestatus bei einem elektronischen batteriebetriebenen Benutzerendgerät nach Anspruch 1.

Weiterhin betrifft die Erfindung ein elektronisches batteriebetriebenes Benutzerendgerät, welches für eine Mehrzahl von Anwendungen für einen Benutzer ausgebildet ist nach Anspruch 4.

Ferner betrifft die Erfindung ein Verfahren zum Darstellen eines Batterieladestatus für ein elektronisches batteriebetriebenes Benutzerendgerät, welches für eine Mehrzahl von Anwendungen für einen Benutzer ausgebildet ist und dazu eine Mehrzahl von elektrischen Komponenten zur Durchführung der Anwendungen und eine Batterie zur Energieversorgung der elektrischen Komponenten enthält nach Anspruch 8.

### Stand der Technik

Als elektronisches Benutzerendgerät wird allgemein ein Endgerät zum elektronischen Erzeugen, Verarbeiten, Austauschen und Wiedergeben von Informationen oder Daten für einen Benutzer bezeichnet. Die Daten oder Informationen können beispielsweise Texte, Sprache, Musik, Bilder, Animationen, Filme oder Multimediadaten sein. Als mobile batteriebetriebene Benutzerendgeräte sind insbesondere Mobilfunktelefone für eine Kommunikation über ein Mobilfunknetz nach dem GSM- (Global System for Mobile Communication) oder UMTS- (Universal Mobile Telecommunications System) Standard, MP3-Player (Wiedergabegeräte für Audiodaten im Moving Picture Experts Group Audio Layer 3 Format), PDAs (Persönliche Digitale Assistenten), Laptops, digitale Kameras, Camcorder und Navigationsgeräte bekannt.

Solche Benutzerendgeräte stellen einem Benutzer zunehmend mehrere Anwendungen zur Verfügung. So enthalten Mobilfunktelefone inzwischen üblicherweise eine digitale Kamera und einen MP3-Player. Weitere Beispiele sind MP3-Player und Navigationsgeräte, welche ein Anzeigen von digitalen Bildern oder Videos ermöglichen, PDAs mit Mobilfunktelefonie oder Mobilfunkendgeräte mit einem integrierten satellitengestützten Navigationssystem. Zudem verfügen viele Benutzerendgeräte über Schnittstellen, wie etwa nach dem Bluetooth- oder USB- (Universal Serial Bus) Standard, um Funktionen oder Anwendungen externer Geräte zu nutzen.

Üblicherweise wird in batteriebetriebenen Benutzerendgeräten als Batterie eine Einwegbatterie oder ein wiederaufladbarer Akkumulator verwendet. Mittels einer Batteriestatusanzeige wird einem Benutzer der Batteriestatus angezeigt. Auf diese Weise wird es dem Benutzer ermöglicht, rechtzeitig eine Batterie auszutauschen oder einen Akkumulator wieder aufzuladen. Ferner kann der Benutzer eine Nutzung des Benutzerendgeräts auf den Batteriestatus abstimmen.

Um eine nachteilhafte vollständige Entladung, eine sogenannte Tiefentladung, eines Akkumulators zu vermeiden und aktive Anwendungen sicher und ohne Datenverlust zu beenden, erfolgt bei einem vorgegebenen Schwellwert typischerweise ein automatisches Ausschalten des Benutzerendgeräts. Bei batteriebetriebenen Benutzerendgeräten mit mehreren Anwendungen ist weiterhin ein frühzeitiges Deaktivieren von Anwendungen oder Funktionen mit geringer Priorität bekannt. Diese Anwendungen oder Funktionen werden bereits vor Erreichen des oben genannten Sehwellwerts deaktiviert, um so ein längere Restlaufzeit einer Batterie für wichtige Anwendungen zu erzielen. Für diese Vorgehensweise können beispielsweise weitere Sehwellwerte verwendet werden. So wird bei aktuellen Mobilfunktelefonen je nach Ladezustand der Batterie beispielsweise zunächst eine Kamera, später eine Bluetooth-Schnittstelle und schließlich die Telefonie und damit das Mobilfunktelefon als solches deaktiviert bzw. ausgeschaltet. Hierdurch wird eine längere Laufzeit für die bevorzugte Telefonie-Anwendung des Mobilfunkendgeräts erzielt.

In der europäischen Patentschrift EP 1202457 Bwird ein Verfahren zum Abschalten eines batteriegespeisten Mobilfunkendgeräts beschrieben. Dabei wird periodisch die aktuelle Batteriespannung ermittelt. Der aktuelle Batteriezustand kann dem Benutzer symbolisch mit einem Batteriesymbol auf einer Anzeige des Mobilfunkendgeräts angezeigt werden. Bei einem Abfall unter einer vorher festgelegten Abschaltspannung wird die Spannungsversorgung des Mobilfunkendgeräts abgeschaltet. Vorher wird dieser Vorgang durch ein Alarmsignal, beispielsweise ein Blinken des Batteriesymbols, für einen Benutzer dargestellt. Für verschiedene Betriebszustände, wie einem Sprachmodus oder einen TX-Übertragungsburst sind verschiedene vorgegebene Abschaltspannungen möglich.

Die bekannten Benutzerendgeräte mit mehreren Anwendungen und einer vom Batteriestatus abhängigen Deaktivierung einzelner Anwendungen haben den Nachteil, dass für einen Benutzer nicht nachvollziehbar ist, ob und wann eine einzelne Anwendung oder Funktion deaktiviert wird. Diese Benutzerendgeräte verfügen zwar über eine Batteriestatusanzeige, welche dem Benutzer einen Ladezustand der Batterie darstellt und ihn auf eine unmittelbar bevorstehende Abschaltung des Benutzerendgeräts aufmerksam macht. Es ist aber für den Benutzer auch mittels der Batteriestatusanzeige nicht erkennbar, wann welche Anwendungen des Benutzerendgeräts deaktiviert werden, da eine Deaktivierung von einem Energiebedarf aktiver Anwendungen und dem Nutzungsverhalten des Benutzers abhängt.

Die DE 103 45 437 A1 offenbart ein Verfahren zum Betrieb eines Mobilfunkendgerätes mit einem Betriebssystem, wobei im Mobilfunkendgerät eine Mehrzahl von Anwendungen vorliegen, die in Anwenderprofilen individuell und/oder vor konfiguriert aktiviert werden, bei dem zumindest eine Anwendung, die im Mobilfunkendgerät aktiv ausgeführt wird oder in einem Bereitschaftszustand ist, zumindest eine elektrische Komponente verwendet und dadurch Energie des Mobilfunkendgeräteakkus verbraucht.

Die WO 2008/101251 A1 offenbart Systeme, Verfahren und Geräte zur Begrenzung des Stromverbrauchs in einem drahtlosen Kommunikationsgerät bereitgestellt, wobei Schwellenwerte für die Leistungsbegrenzung vorgesehen sind, um Leistung für eine oder mehrere vorbestimmte Anwendungen, die von dem drahtlosen Kommunikationsgerät ausgeführt werden können, zu reservieren oder deren Leistungsverbrauch zu begrenzen.

Die US 2003/0158609 A1 offenbart ein Energieverwaltungssystem für ein tragbares Gerät, welches eine Vielzahl von Techniken zur dynamischen Steuerung der Energiezuweisung zwischen den Komponenten des tragbaren Geräts verwendet. Ein Schema mit Leistungspriorität deaktiviert dabei schrittweise einzelne Komponenten des Geräts oder reduziert deren Leistung, so dass weniger wichtige Funktionen früher deaktiviert werden, um eine längere Leistungsdauer für wichtigere Funktionen, wie z. B. Datenspeicherfunktionen, bereitzustellen.

Die US 2009/0164152 A1 offenbart ein Verfahren, eine Vorrichtung und ein Computerprogrammprodukt, um eine Benachrichtigung über den Stromverbrauch und dessen Verwaltung zu ermöglichen. Insbesondere können Anwendungsstromverbrauchsmodelle und Gerätebatterie-Energiepegel verwendet werden, um eine Geräteentladungsdauer zu bestimmen. Eine Geräte-Energieverbrauchsrate kann aus Anwendungs-Energieverbrauchsmodellen bestimmt werden.

### Offenbarung der Erfindung

Aufgabe der Erfindung ist es daher, Nachteile des Standes der Technik zu vermeiden und einen Benutzer effektiv und benutzerfreundlich über eine Deaktivierung einzelner Anwendungen zu informieren.

Erfindungsgemäß wird die Aufgabe mit einer Anzeigevorrichtung, einem Benutzerendgerät und einem Verfahren gemäß der beigefügten Ansprüche gelöst.

Die Erfindung beruht auf dem Prinzip, für verschiedene Anwendungen, welche bei unterschiedlichen, vorgegebenen Batterieladestatus und somit zu unterschiedlichen Zeitpunkten deaktiviert werden, jeweils einen anwendungsspezifischen Batterieladezustand anzuzeigen. Der anwendungsspezifische Batterieladezustand unterscheidet sich von dem Batterieladestatus durch Berücksichtigung der vom Batterieladestatus abhängigen Deaktivierung der Anwendung. Wird beispielsweise eine Anwendung durch die Energieversorgungssteuerung bei halbvoller Batterie deaktiviert, so zeigt der anwendungsspezifische Batterieladezustand dieser Anwendung bei halbvoller Batterie z.B. einen ungenügenden Ladezustand oder eine "leere" Batterie an.

Bei der erfindungsgemäßen Anzeigevorrichtung und dem erfindungsgemäßen Benutzerendgeräts wird dem Benutzer für jede Anwendung ein anwendungsspezifischer Batterieladezustand angezeigt. Diese Information weist den Benutzer sehr effektiv auf eine bevorstehende Deaktivierung einer Anwendung hin. Dem Benutzer wird benutzerfreundlich ermöglicht, sein Nutzungsverhalten entsprechend der ermittelten und angezeigten anwendungsspezifischen Batterieladezustände anzupassen. Insbesondere wird der Benutzer nicht von einer Deaktivierung einer Anwendung überrascht, obwohl der Batterieladestatus des Benutzerendgeräts noch genügend Batterieladung für einen Betrieb des Benutzerendgeräts anzeigt.

Entsprechende Vorteile ergeben sich bei dem erfindungsgemäßen Verfahren zum Darstellen eines Batterieladestatus für ein elektronisches batteriebetriebenes Benutzerendgerät. Wiederum wird der Benutzer rechtzeitig über eine Deaktivierung einer Anwendung informiert und kann sein Nutzugsverhalten entsprechend ausrichten.

Bei der erfindungsgemäßen Anzeigevorrichtung sind Ladestatusmittel zum Ermitteln des anwendungsspezifischen Batterieladezustandes einer Anwendung mittels des Batterieladestatus und eine vorgegebene Priorität der Anwendung für eine Deaktivierung ausgebildet. Hierdurch eignet sich die erfindungsgemäße Anzeigevorrichtung besonders für Benutzerendgeräte, welche verschiedenen Anwendungen unterschiedliche Prioritäten zuweisen und einzelne Anwendungen jeweils in Abhängigkeit von einem Batterieladestatus und einer Priorität deaktivieren. Bei solchen Benutzerendgeräten wird das Ermitteln des anwendungsspezifischen Batterieladezustandes durch diese Ausbildung unkompliziert und schnell durchführbar.

Die erfindungsgemäße Anzeigevorrichtung umfasst Laufzeitbestimmungsmittel zum Bestimmen und Anzeigen einer Restlaufzeit einer Anwendung je nach anwendungsspezifischem Batterieladestatus und einem Energieverbrauch aktiver Anwendungen. Auf diese Weise wird ein Benutzer sehr benutzerfreundlich über Restlaufzeiten einzelner Anwendungen informiert und kann sein Nutzungsverhalten entsprechend anpassen. Der Benutzer erhält für verschiedene Anwendungen jederzeit Kenntnis über einen Zeitpunkt der Deaktivierung der Anwendung. Dadurch wird eine für den Benutzer überraschende Deaktivierung effektiv vermieden.

Durch Schaltmittel zum Aktivieren- oder Deaktivieren mindestens einer Anwendung durch den Benutzer wird eine vorteilhafte Weiterbildung der erfindungsgemäßen Anzeigevorrichtung erreicht. Mit dieser Maßnahme wird dem Benutzer eine umfangreiche Einflussnahme auf die Deaktivierung von Anwendungen ermöglicht. Je nach Bedarf ist eine Deaktivierung von nicht benötigten Anwendungen durchführbar. Dies führt zu einer längeren Restlaufzeit der verbleibenden aktiven Anwendungen. Ferner ist gegebenenfalls auch eine Aktivierung einer bereits deaktivierten Anwendung möglich, falls der Benutzer eine solche Anwendung dringend benutzen möchte.

Die erfindungsgemäße Anzeigevorrichtung sieht Mittel zum Anzeigen einer Batterieauslastung durch eine Anwendung vor. Je nach Energiebedarf belasten verschiedene Anwendungen bzw. für diese Anwendung verwendete elektrische Komponenten des Benutzerendgeräts die Batterie unterschiedlich stark. Durch Anzeigen der Batterieauslastung oder des Energiebedarfs einer Anwendung erhält der Benutzer wichtige Informationen, nach denen er sein Nutzungsverhalten ausrichten kann. Beispielsweise wird hierdurch eine Entscheidung zum Nichtbenutzen oder Deaktivieren einer Anwendung wesentlich erleichtert.

Ferner umfasst die erfindungsgemäße Anzeigevorrichtung Stellmittel zum Vorgeben oder Ändern der Priorität einer Anwendung für eine Deaktivierung. Mit den Stellmitteln wird anwendungsfreundlich eine Anpassung der Priorität einer Anwendung für eine Deaktivierung in Abhängigkeit des Batterieladestatus ermöglicht. Je nach Bedürfnissen und Wünschen des Benutzers lässt sich eine Reihenfolge von automatischen Deaktivierungen verschiedener Anwendungen vorteilhaft durch den Benutzer einstellen.

Bei einer bevorzugten Ausgestaltung des erfindungsgemäßen batteriebetriebenen Benutzerendgeräts sind die Ladestatusmittel zum Ermitteln des anwendungsspezifischen Batterieladezustandes einer Anwendung mittels des Batterieladestatus und einer vorgegebenen Priorität der Anwendung für eine Deaktivierung ausgebildet. Anhand einer vorgegebenen Priorität wird eine Anwendung durch eine Energieversorgungssteuerung bei einem vorgegebenen Batterieladestatus deaktiviert. Dabei ist eine gleichzeitige Deaktivierung von mehreren Anwendungen gleicher Priorität möglich. Durch Nutzung der Priorität einer Anwendung und des Batterieladestatus des Benutzerendgeräts wird ein effizientes Ermitteln von anwendungsspezifischen Batterieladezuständen durchführbar.

Das Benutzerendgerät ist in einer vorteilhaften Ausbildung der Erfindung ein Mobilfunkendgerät für ein Mobilfunknetz. Moderne Mobilfunkendgeräte stellen einem Benutzer üblicherweise eine Vielzahl von Anwendungen, wie beispielsweise Telefonie, Textnachrichten, Spiele, Erzeugen und Anzeigen von Fotos und Videos und Wiedergabe von Musik, zur Verfügung. Die Erfindung lässt sich daher besonders vorteilhaft bei Mobilfunkendgeräten einsetzen. Ein als Mobilfunkendgerät ausgebildetes erfindungsgemäßes Benutzerendgerät informiert den Benutzer zu allen Zeiten über anwendungsspezifische Batterieladezustände der Anwendungen und somit auch über bevorstehende Deaktivierungen einzelner Anwendungen.

Eine bevorzugte Ausbildung des erfindungsgemäßen Verfahrens zum Darstellen eines Batterieladestatus für ein elektronisches batteriebetriebenes Benutzerendgerät verwendet zum Ermitteln des anwendungsspezifischen Batterieladezustandes einer Anwendung ebenfalls den Batterieladestatus und eine vorgegebene Priorität der Anwendung für eine Deaktivierung. Entsprechend der jeweiligen Ausgestaltung des erfindungsgemäßen Benutzerendgeräts und der erfindungsgemäßen Anzeigevorrichtung wird auf diese Weise ein schnelles und effizientes Ermitteln von anwendungsspezifischen Batterieladezuständen ermöglicht.

Weitere Ausbildungen des erfindungsgemäßen Benutzerendgeräts und des erfinderischen Verfahrens korrespondieren jeweils mit einer oben beschriebenen Ausgestaltung der Anzeigevorrichtung und verfügen daher über entsprechende Vorteile.

Ferner ergeben sich weitere Ausgestaltungen und Vorteile aus dem Gegenstand der Unteransprüche, sowie der Zeichnungen mit der dazugehörigen Beschreibung.

Ein Ausführungsbeispiel der Erfindung ist nachstehend unter Bezugnahme auf die zugehörigen Zeichnungen näher erläutert.

### Kurze Beschreibung der Zeichnungen

- Fig. 1: zeigt in einer schematischen Prinzipskizze ein Ausführungsbeispiel einer erfindungsgemäßen Anzeigevorrichtung für ein Benutzerendgerät.
- Fig. 2: zeigt einen schematischen Ausschnitt einer Anzeige des Ausführungsbeispiels nach Fig. 1.

### Bevorzugtes Ausführungsbeispiel

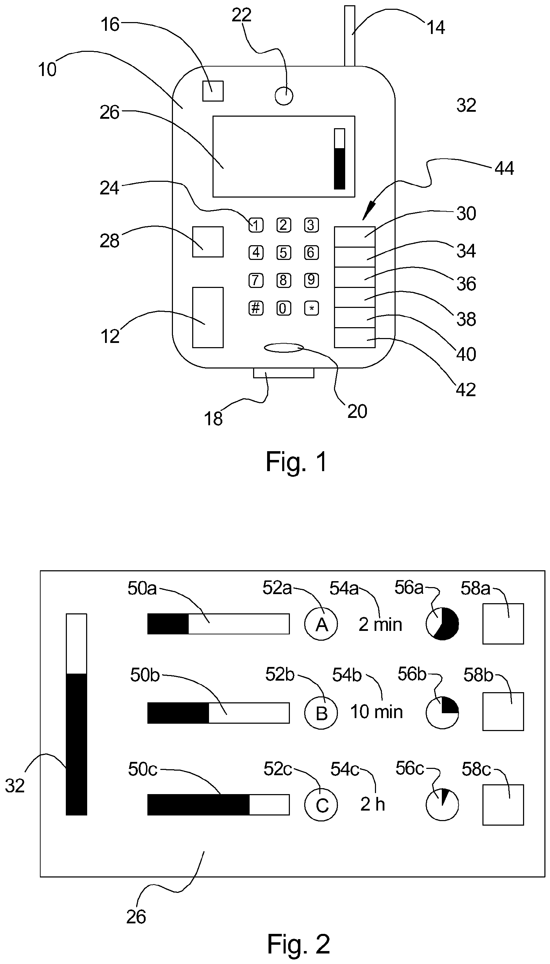

In Fig. 1 wird mit 10 ein elektronisches batteriebetriebenes Benutzerendgerät bezeichnet. Zur Energieversorgung des Benutzerendgeräts 10 ist eine wiederaufladbare Batterie 12 vorgesehen. Alternativ ist auch eine Verwendung einer Einwegbatterie möglich. Das Benutzerendgerät 10 ist in diesem Ausführungsbeispiel als Mobilfunkendgerät ausgebildet und enthält neben anderen, einem Fachmann bekannten Bestandteilen insbesondere ein Mobilfunkmodul 14 zum Senden und Empfangen von Daten über ein Mobilfunknetz nach dem GSM- (Global System for Mobile Communication) oder UMTS- (Universal Mobile Telecommunications System) Standard.

In anderen Ausführung ist das Benutzerendgerät 10 beispielsweise als MP3-Player (Wicdcrgabcgcrät für Audiodaten im Moving Picturc Exports Group Audio Layer 3 Format), PDA (Persönlicher Digitaler Assistent), Laptop, digitale Kamera, Camcorder oder Navigationsgerät ausgebildet. Allgemein zeichnet sich das elektronische batteriebetriebene Benutzerendgerät 10 durch elektronisches Erzeugen, Verarbeiten, Austauschen und Wiedergeben von Informationen oder Daten für einen Benutzer aus. Es stellt somit eine Schnittstelle zwischen einem Benutzer und elektronischen vorliegenden Daten oder Informationen dar. Daten oder Informationen können beispielsweise Texte, Sprache, Musik, Bilder, Animationen, Filme oder Multimediadaten sein.

Das Benutzerendgerät 10 stellt dem Benutzer mehrere Anwendungen zur Verfügung und enthält dazu notwenige elektrische Komponenten. Als Anwendungen sind beispielsweise möglich: Telefonie, WAP- (Wireless Application Protocol), SMS- (Short Message Service), EMS- (Enhanced Messaging Service) und MMS- (Multimedia Messaging Service) Anwendungen, E-Mail, Internet, WWW (World Wide Web), Organizer, Adressbuch, Aufnahme von Bildern oder Videos, Wiedergabe von Musik, Bildern oder Videos, Spiele, satellitengestützte Navigation und verschiedene Schnittstellen zur Nutzung von Anwendungen mit externen Geräten, wie z.B. USB (Universal Serial Bus), Bluetooth oder IrDa (Infrared Data Association).

Der Einfachheit halber werden im Folgenden nur drei Anwendungen des Benutzerendgeräts 10 exemplarisch näher betrachtet. Erstens ermöglicht das Benutzerendgerät 10 eine Aufnahme von Bildern oder Videos und enthält dafür als elektrische Komponente eine digitale Kamera 16. Zweitens ist eine Anwendung von externen Geräten über eine Bluetooth-Schnittstelle 18 als elektrische Komponente durchführbar. Und drittens ermöglicht das Benutzerendgerät 10 dem Benutzer Telefonie und enthält dazu neben einem Mikrofon 20, einem Lautsprecher 22 und dem Mobilfunkmodul 14 alle weiteren dafür notwendigen elektrischen Komponenten.

Zur Steuerung und Nutzung des Benutzerendgeräts 10 durch einen Benutzer sind eine Bedienungseinheit 24 und eine Anzeige 26 vorgesehen. Mit der Anzeige 26 lassen sich neben Kontroll-, Status- und Steuerungsinformationen des Benutzerendgeräts 10 auch Anwendungsdaten, wie beispielsweise Bilder oder Videos darstellen.

Mit einer Energieversorgungssteuerung 28 wird eine Energieversorgung der elektrischen Komponenten des Benutzerendgeräts 10 gesteuert. Einerseits schaltet die Energieversorgungssteuerung 28 das Benutzerendgerät 10 bei einer vorgegebenen Mindestladung der Batterie 12 ab und beendet dazu alle Anwendungen bzw. deaktiviert alle elektrischen Komponenten des Benutzerendgeräts 10. Auf diese Weise werden alle Anwendungen ordnungsgemäß beendet und eine schädliche vollständige Entladung der Batterie 12 vermieden. Andererseits werden durch die Energieversorgungssteuerung 28 einzelne Anwendungen bzw. die entsprechenden elektrischen Komponenten bereits vor Erreichen der Mindestladung bei weiteren vorgegebenen Restladungen der Batterie 12 deaktiviert, um eine Laufzeit wichtiger Anwendungen zu erhöhen. Dazu verwendet die Energieversorgungssteuerung 28 vorgegebene Prioritäten der Anwendungen und diesen zugeordnete Restladungswerte der Batterie 12. Beim Erreichen eines dieser Restladungswerte werden alle Anwendungen mit der entsprechenden Priorität deaktiviert.

Der Ladungszustand der Batterie 12 wird als Batterieladestatus durch eine Erfassungsvorrichtung 30 erfasst. Dazu kann beispielsweise eine kontinuierliche oder periodische Überprüfung der Batteriespannung erfolgen. Der Batterieladestatus kann z.B. in Prozenten vorliegen und reicht dann von 100 % für eine vollständig geladene Batterie 12 bis 0% für eine entladene Batterie 12. Durch einen Vergleich des aktuellen Batterieladestatus mit vorgegebenen Batterieladestatus als vorgegebene Restladungswerte stellt die Energieversorgungssteuerung 28 fest, ob einzeln Anwendungen oder das gesamte Benutzerendgerät 10 deaktiviert werden müssen. Der Batterieladestatus wird in diesem Ausführungsbeispiel als Balken 32 auf der Anzeige 26 für den Benutzer dargestellt. Ein vollständig gefüllter Balken 32 entspricht einer vollständig geladenen Batterie 12 und ein Balken 32 ohne Füllung einer entladenen Batterie 12.

Weiterhin enthält das Benutzerendgerät 10 Ladestatusmittel 34 zum Ermitteln und Anzeigen eines anwendungsspezifischen Batterieladezustands für jede Anwendung. Der anwendungsspezifische Batterieladezustand unterscheidet sich von dem Batterieladestatus durch Berücksichtigung der vom Batterieladestatus abhängigen Deaktivierung einer Anwendung. Dieser Umstand wird weiter unten näher bcschricbcn. Die Ladestatusmittel 34 ermitteln den anwendungsspezifischen Batterieladezustand einer Anwendung mit Hilfe des aktuellen Batterieladestatus und der vorgegebenen Priorität der jeweiligen Anwendung.

Mit Laufzeitbestimmungsmittel 36 wird anhand des anwendungsspezifischen Batterieladezustands einer Anwendung und einem Energieverbrauch aktiver Anwendungen eine Restlaufzeit für jede Anwendung ermittelt und für den Benutzer auf der Anzeige 26 dargestellt. Ferner wird eine Batterieauslastung oder ein Energieverbrauch einer Anwendung durch Mittel 38 zum Anzeigen der Batterieauslastung einer Anwendung für den Benutzer auf der Anzeige 26 dargestellt (s. Fig. 2).

Zum Vorgeben oder Ändern der Priorität einer Anwendung durch den Benutzer sind in dem Benutzerendgerät 10 Stellmittel 40 vorgesehen. Weiterhin ist ein Aktivieren oder Deaktivieren einzelner Anwendungen durch den Benutzer mit Schaltmitteln 42 möglich. Die Stellmittel 40 und die Schaltmittel 42 werden von dem Benutzer mit Hilfe der Bedienungseinheit 24 und der Anzeige 26 betätigt. Dazu können beispielsweise Menüs, Symbole oder Softkey auf der Anzeige 26 verwendet werden, welche der Benutzer mit Hilfe der Bedienungseinheit 24 auswählt.

Die Erfassungsvorrichtung 30, die Anzeige 26, die Ladestatusmittel 34, die Laufzeitbestimmungsmittel 36, die Mittel zum Anzeigen der Batterieauslastung 38, sowie die Prioritätsstellmittel 40 und die Schaltmittel 42 bilden zusammen eine Anzeigevorrichtung 44 zum Darstellen eines Batterieladestatus und anwendungsspezifischer Batterieladezustände. Statt der Anzeige 26 des Benutzerendgeräts 10 ist auch eine Verwendung einer weiteren Anzeige möglich. Entsprechendes gilt auch für die Erfassungsvorrichtung 30.

Im Folgenden wird die Funktionsweise der Anzeigevorrichtung 44 zusammen mit einem entsprechenden beispielhaften Verfahren zum Darstellen eines Batterieladestatus und anwendungsspezifischer Batterieladezustände beschrieben. Dabei wird sowohl auf Fig. 1 als auch auf Fig. 2 Bezug genommen. Gleiche Bestandteile werden in Fig. 1 und Fig. 2 mit entsprechenden Bczugszcichcn bczcichnct. Wie bereits erwähnt, werden exemplarisch drei Anwendungen und deren elektrische Komponenten, nämlich die digitale Kamera 16, die Bluetooth-Schnittstelle 16 und Telefonie betrachtet. Die Anzeigevorrichtung 44 und das Verfahren können aber auch für weniger oder mehr Anwendungen verwendet werden.

Bei einer Benutzung des Benutzerendgeräts 10 wird dem Benutzer permanent der Batterieladestatus als Balken 32 dargestellt, s. Fig. 1. Um weitere Informationen, insbesondere über eine Deaktivierung von Anwendungen zu erhalten, ruft der Benutzer mittels der Bedienungseinheit 24 die Anzeigevorrichtung 44 auf. Dazu kann beispielsweise der Balken 32 als anwählbares Symbol oder Softkey ausgebildet sein. Die Anzeigevorrichtung 44 stellt daraufhin unter anderem anwendungsspezifische Batterieladezustände, Restlaufzeiten und Batterieauslastungen einzelner Anwendungen auf der Anzeige 26 für den Benutzer dar.

In Fig. 2 wird ein schematischer und beispielhafter Ausschnitt der Anzeige 26 mit diesen Informationen dargestellt. Neben dem Balken 32 des Batterieladestatus wird für die digitale Kamera 16 ein anwendungsspezifischer Batterieladezustand als Balken 50a zusammen mit einem Symbol oder einer Text 52a als Bezeichner dargestellt. Da die digitale Kamera 16 eine niedrige Priorität besitzt und vor der Bluetooth-Schnittstelle 18 und der Telefonie von der Energieversorgungssteuerung 28 deaktiviert wird, unterscheidet sich der anwendungsspezifische Batterieladezustand 50a der digitalen Kamera 16 von dem Batterieladestatus 32.

Weiterhin wird für die digitale Kamera 16 eine Restlaufzeit 54a bis zur Deaktivierung und eine Batterieauslastung 56a dargestellt. Die Batterieauslastung 56a beschreibt den Energiebedarf der digitalen Kamera 16. Alle diese Werte können als Text oder symbolisch dargestellt werden. Ferner wird durch ein Symbol 58a als Status der digitalen Kamera 16 dargestellt, ob die digitale Kamera 16 aktiviert oder deaktiviert ist. Dieses Symbol 58a dient dem Benutzer gleichzeitig als anwählbares Symbol oder Softkey zur Bedienung der Schaltmittel 42 zum Aktivieren oder Deaktivieren der digitalen Kamera 16.

Entsprechend wird für die Bluetooth-Schnittstelle 18 ein anwendungsspezifischer Batterieladezustand 50b, ein Bezeichner 52b, eine Restlaufzeit 54b, eine Batterieauslastung 56b und ein Status- und Schaltsymbol 58b und für die Telefonie ein anwendungsspezifischer Batterieladezustand 50c, ein Bezeichner 52c, eine Restlaufzeit 54c, eine Batterieauslastung 56c und ein Status- und Schaltsymbol 58b dargestellt. Die Bluetooth-Schnittstelle 18 besitzt eine mittlere Priorität, während die Telefonie über eine hohe Priorität verfügt. Die Telefonie wird deshalb zusammen mit dem Benutzerendgerät 10 von der Energieversorgungssteuerung 28 bei der Mindestladung der Batterie für einen Betrieb deaktiviert. Der anwendungsspezifische Batterieladezustand 50c der Telefonie entspricht somit dem Batterieladestatus 32. Da die Bluetooth-Schnittstelle 18 bei einem Restladungswert der Batterie 12 zwischen dem der digitalen Kamera 16 und der Mindestladung der Batterie von der Energieversorgungssteuerung 28 deaktiviert wird, unterscheidet sich der anwendungsspezifische Batterieladezustand 50b der Bluetooth-Schnittstelle 18 sowohl von dem der digitalen Kamera 16 als auch von dem der Telefonie.

Durch die Anzeigevorrichtung 44 und das entsprechenden Verfahren erhält der Benutzer umfangreiche Informationen, um sich auf bevorstehende Deaktivierungen einzelner Anwendungen vorzubereiten und sein Nutzungsverhalten entsprechend auszurichten. Weiterhin wird dem Benutzer durch die in der Anzeigevorrichtung 44 vorgesehenen Stellmittel 40 für die Priorität und die Schaltmittel 42 eine weitreichende Einflussnahme auf das Deaktivieren und Aktivieren von Anwendungen durch das Benutzerendgerät 10 ermöglicht.

## Patentansprüche

1. Anzeigevorrichtung (44) zum Darstellen eines Batterieladestatus (32) bei einem elektronischen batteriebetriebenen Benutzerendgerät (10), welches für eine Mehrzahl von Anwendungen für einen Benutzer ausgebildet ist, wobei
a) das Benutzerendgerät (10)
- eine Mehrzahl von elektrischen Komponenten (16, 18) zur Durchführung der Anwendungen,
- eine Batterie (12) zur Energieversorgung der elektrischen Komponenten (16, 18) und
- eine Energieversorgungssteuerung (28) zum Deaktivieren der elektrischen Komponenten (16, 18) einzelner Anwendungen bei jeweils einem vorgegebenen Batterieladestatus umfasst und
b) die Anzeigevorrichtung (44) des Benutzerendgeräts (10)
- eine Erfassungsvorrichtung (30) zum Erfassen des Batterieladestatus (32) des Benutzerendgeräts,
- eine Anzeige (26) zum Darstellen des Batterieladestatus (32) des gesamten Benutzerendgeräts (10),
- Ladestatusmittel (34) zum Ermitteln und Anzeigen eines anwendungsspezifischen Batterieladezustandes (50a, 50b, 50c) für mindestens eine der Anwendungen,
- Laufzeitbestimmungsmittel (36) zum Bestimmen und Anzeigen einer Restlaufzeit (54a, 54b, 54c) einer Anwendung je nach anwendungsspezifischem Batterieladezustand (50a, 50b, 50c) und einem Energieverbrauch aktiver Anwendungen,
und Stellmittel (40) zum Vorgeben oder Ändern der Priorität einer Anwendung für eine Deaktivierung umfasst, **dadurch gekennzeichnet, dass** die Anzeigevorrichtung (44) Mittel (38) zum Anzeigen einer jeweiligen Batterieauslastung (56a, 56b, 56c) durch eine Anwendung umfasst.

2. Anzeigevorrichtung (44) nach Anspruch 1, **dadurch gekennzeichnet, dass** die Ladestatusmittel (34) zum Ermitteln des anwendungsspezifischen Batterieladezustandes (50a, 50b, 50c) einer Anwendung mittels des Batterieladestatus (32) und einer vorgegebenen Priorität der Anwendung für eine Deaktivierung ausgebildet sind.

3. Anzeigevorrichtung (44) nach Anspruch 1 oder Anspruch 2, **dadurch gekennzeichnet, dass** Schaltmittel (42) zum Aktivieren- oder Deaktivieren mindestens einer Anwendung durch den Benutzer vorgesehen sind.

4. Elektronisches batteriebetriebenes Benutzerendgerät (10), welches für eine Mehrzahl von Anwendungen für einen Benutzer ausgebildet ist, wobei das Benutzerendgerät (10)
- eine Mehrzahl von elektrischen Komponenten (16, 18) zur Durchführung der Anwendungen,
- eine Batterie (12) zur Energieversorgung der elektrischen Komponenten (16, 18),
- eine Energieversorgungssteuerung (28) zum Deaktivieren der elektrischen Komponenten (16, 18) einzelner Anwendungen bei jeweils einem vorgegebenen Batterieladestatus, sowie
- eine Anzeigevorrichtung (44) mit
- einer Erfassungsvorrichtung (30) zum Erfassen eines Batterieladestatus (32) des Benutzerendgeräts (10),
- einer Energieversorgungssteuerung (28) zum Deaktivieren der elektrischen Komponenten (16, 18) einzelner Anwendungen bei jeweils einem vorgegebenen Batterieladestatus,
- einer Anzeige (26) zum Darstellen des gesamten Batterieladestatus (32) des Benutzerendgeräts (10),
- Ladestatusmitteln (34) zum Ermitteln und Anzeigen eines anwendungsspezifischen Batterieladezustandes (50a, 50b, 50c) für mindestens eine der Anwendungen,
- Laufzeitbestimmungsmitteln (36) zum Bestimmen und Anzeigen einer Restlaufzeit (54a, 54b, 54c) einer Anwendung je nach anwendungsspezifischem Batterieladezustand (50a, 50b, 50c) und einem Energieverbrauch aktiver Anwendungen,
und Stellmitteln (40) zum Vorgeben oder Ändern der Priorität einer Anwendung für eine Deaktivierung, umfasst, **dadurch gekennzeichnet, dass** die Anzeigevorrichtung (44) Mittel zum Anzeigen einer jeweiligen Batterieauslastung durch eine Anwendung umfasst.

5. Elektronisches batteriebetriebenes Benutzerendgerät (10) nach Anspruch 4, **dadurch gekennzeichnet, dass** die Ladestatusmittel (34) zum Ermitteln des anwendungsspezifischen Batterieladezustandes (50a, 50b, 50c) einer Anwendung mittels des Batteriestatus (32) und einer vorgegebenen Priorität der Anwendung für eine Deaktivierung ausgebildet sind.

6. Elektronisches batteriebetriebenes Benutzerendgerät (10) nach Anspruch 4 oder Anspruch 5, **dadurch gekennzeichnet, dass** Schaltmittel (42) zum Aktivieren- oder Deaktivieren mindestens einer Anwendung durch den Benutzer vorgesehen sind.

7. Elektronisches batteriebetriebenes Benutzerendgerät (10) nach einem der Ansprüche 4 bis 6, **dadurch gekennzeichnet, dass** das Benutzerendgerät (10) ein Mobilfunkendgerät für ein Mobilfunknetz ist.

8. Verfahren zum Darstellen eines Batterieladestatus (32) für ein elektronisches batteriebetriebenes Benutzerendgerät (10), welches für eine Mehrzahl von Anwendungen für einen Benutzer ausgebildet ist und dazu eine Mehrzahl von elektrischen Komponenten (16, 18) zur Durchführung der Anwendungen und eine Batterie (12) zur Energieversorgung der elektrischen Komponenten (16, 18) enthält, mit den Verfahrensschritten:
- Erfassen des Batterieladestatus (32) durch eine Erfassungseinheit (30),
- Deaktivieren der elektrischen Komponenten (16, 18) einzelner Anwendungen bei jeweils einem vorgegebenen Batterieladestatus durch eine Energieversorgungssteuerung (28),
- Darstellen des Batteriestatus (32) auf einer Anzeige (26),
- Ermitteln und Anzeigen eines anwendungsspezifischen Batterieladezustandes (50a, 50b, 50c) für mindestens eine der Anwendungen durch Ladestatusmittel (34),
- Bestimmen und Anzeigen einer Restlaufzeit (54a, 54b, 54c) einer Anwendung je nach anwendungsspezifischem Batterieladezustand (50a, 50b, 50c) und einem Energieverbrauch aktiver Anwendungen durch Laufzeitbestimmungsmittel (36),
und ein Vorgeben oder Ändern der Priorität einer Anwendung durch Stellmittel (40), **gekennzeichnet durch** Anzeigen einer jeweiligen Batterieauslastung (56a, 56b, 56c), welche durch eine Anwendung verursacht wird.

9. Verfahren nach Anspruch 8, **dadurch gekennzeichnet, dass** zum Ermitteln des anwendungsspezifischen Batterieladezustandes (50a, 50b, 50c) einer Anwendung der Batterieladestatus (32) und eine vorgegebene Priorität der Anwendung für eine Deaktivierung verwendet werden.

10. Verfahren nach Anspruch 8 oder Anspruch 9, **dadurch gekennzeichnet, dass** ein Aktivieren oder Deaktivieren mindestens einer Anwendung durch den Benutzer vorgesehen ist.

## Claims

1. A display device (44) for representing a battery charging status (32) in an electronic battery-operated user terminal (10), which is configured for a plurality of applications for a user, wherein
a) the user terminal (10) comprises
- a plurality of electric components (16, 18) for carrying out the applications,
- a battery (12) for the energy supply of the electric components (16, 18) and
- an energy supply control (28) for deactivating the electric components (16, 18) of individual applications in case of a respectively predetermined battery charging status
and
b) the display device (44) of the user terminal (10) comprises
- a detection device (30) for detecting the battery charging status (32) of the user terminal,
- a display (26) for representing the battery charging status (32) of the entire user terminal (10),
- charging status means (34) for determining and displaying an application-specific battery charging status (50a, 50b, 50c) for at least one of the applications,
- time determining means (36) for determining and displaying a remaining time (54a, 54b, 54c) of an application depending on the application-specific battery charging state (50a, 50b, 50c) and an energy consumption of active applications,
and
- adjusting means (40) for defining or changing the priority of an application for a deactivation, **characterized in that** the display device (44) comprises means (38) for displaying a respective battery utilization (56a, 56b, 56c) by an application.

2. A display device (44) according to claim 1, **characterized in that** the charging status means (34) for determining and displaying the application-specific battery charging status (50a, 50b, 50c) of an application are configured for a deactivation on the base of the battery charging state (32) and a predetermined priority of the application.

3. A display device (44) according to claim 1 or claim 2, **characterized in that** switching means (42) for activating or deactivating at least one application by the user are provided.

4. An electronic battery-operated user terminal (10), which is configured for a plurality of applications for a user, wherein the user terminal (10) comprises
- a plurality of electric components (16, 18) for carrying out the applications,
- a battery (12) for the energy supply of the electric components (16, 18) and
- an energy supply control (28) for deactivating the electric components (16, 18) of individual applications in case of a respectively predetermined battery charging status, as well as
- a display device (44) comprising
- a detection device (30) for detecting a battery charging status (32) of the user terminal,
- an energy supply control (28) for deactivating the electric components (16, 18) of individual applications in case of a respectively predetermined battery charging status
- a display (26) for representing the entire battery charging status (32) of the user terminal (10),
- charging status means (34) for determining and displaying an application-specific battery charging status (50a, 50b, 50c) for at least one of the applications,
- time determining means (36) for determining and displaying a remaining time (54a, 54b, 54c) of an application depending on the application-specific battery charging state (50a, 50b, 50c) and an energy consumption of active applications,
and
- adjusting means (40) for defining or changing the priority of an application for a deactivation, **characterized in that** the display device (44) comprises means for displaying a respective battery utilization by an application.

5. An electronic battery-operated user terminal (10) according to claim 4, **characterized in that** the charging status means (34) for determining the application-specific battery charging state (50a, 50b, 50c) of an application are configured for a deactivation on the base of the battery status (32) and a predetermined priority of the application.

6. An electronic battery-operated user terminal (10) according to claim 4 or claim 5, **characterized in that** switching means (42) are provided for the user for activating or deactivating at least one application.

7. An electronic battery-operated user terminal (10) according to one of the claims 4 to 6, **characterized in that** the user terminal (10) is a mobile terminal for a mobile radio network.

8. A method for representing a battery charging status (32) of an electronic battery-operated user terminal (10), which is configured for a plurality of applications for a user, and which therefore comprises a plurality of electric components (16, 18) for carrying out the applications and a battery (12) for supplying energy to the electric components (16, 18), comprising the process steps:
- detecting the battery status (32) by means of a detection unit (30),
- deactivating the electric components (16, 18) of individual applications in case of a respectively predefined battery charging status by means of an energy supply control (28),
- representing the battery status (32) on a display (26),
- determining and displaying of an application-specific battery charging state (50a, 50b, 50c) for at least one of the applications by means of charging status means (34),
- determining and displaying a remaining time (54a, 54b, 54c) of an application depending on the application-specific battery charging state (50a, 50b, 50c) and an energy consumption of active applications by means of time-determining means (36),
- and predefining or changing the priority of an application by means of adjusting means (40), **characterized by** displaying a respective battery utilization (56a, 56b, 56c), which is caused by an application.

9. A method according to claim 8, **characterized in that** for determining the application-specific battery charging state (50a, 50b, 50c) of an application the battery charging status (32) and a predefined priority of the application are used for a deactivation.

10. A method according to claim 8 or claim 9, **characterized in that** an activation or deactivation of at least one application by the user is provided.

## Revendications

1. Dispositif d'affichage (44) destiné à représenter un état de chargement (32) d'un terminal d'utilisateur (10) électronique et fonctionnant à piles, lequel est configuré pour une pluralité d'applications pour un utilisateur, dans lequel
a) le terminal d'utilisateur (10) comprend
- une pluralité de composants électriques (16, 18) pour effectuer les applications,
- une pile (12) pour l'alimentation en énergie des composants électriques (16, 18) et
- une commande d'alimentation en énergie (28) pour désactiver les composants électriques (16, 18) des applications individuelles dans le cas d'un état de chargement de pile prédéterminé respectif,
et
b) le dispositif d'affichage (44) du terminal d'utilisateur (10) comprend
- un dispositif de détection (30) pour détecter l'état de chargement de pile (32) du terminal d'utilisateur,
- un afficheur (26) pour représenter l'état de chargement de pile (32) du terminal d'utilisateur entier (10),
- des moyens d'état de chargement (34) pour déterminer et afficher un état de chargement de pile spécifique d'une application (50a, 50b, 50c) pour au moins l'une des applications,
- des moyens de détermination du temps de marche restant (36) pour déterminer et afficher une durée résiduelle (54a, 54b, 54c) d'une application en fonction de l'état de chargement de pile spécifique de l'application (50a, 50b, 50c) et d'une consommation d'énergie des applications actives,
et
- des moyens de réglage (40) pour définir ou changer la priorité d'une application pour une désactivation, **caractérisé en ce que** le dispositif d'affichage (44) comprend des moyens (38) destinés à afficher l'utilisation de pile respective (56a, 56b, 56c) par une application.

2. Dispositif d'affichage (44) selon la revendication 1 ou la revendication 2, **caractérisé en ce que** les moyens d'état de chargement (34) pour déterminer l'état de chargement de pile spécifique de l'application (50a, 50b, 50c) d'une application sont configurés pour une désactivation sur la base de l'état de chargement de pile (32) et d'une priorité prédéterminée de l'application.

3. Dispositif d'affichage (44) selon la revendication 1 ou la revendication 2, **caractérisé en ce que** des moyens de commutation (42) sont prévus pour activer ou désactiver au moins une application par l'utilisateur.

4. Terminal d'utilisateur électronique et fonctionnant à piles (10), qui est configuré pour une pluralité d'applications pour un utilisateur, dans lequel le terminal d'utilisateur (10) comprend
- une pluralité de composants électriques (16, 18) pour effectuer les applications,
- une pile (12) pour l'alimentation en énergie des composants électriques (16, 18),
- une commande d'alimentation en énergie (28) pour désactiver les composants électriques (16, 18) des applications individuelles dans le cas d'un état de chargement de pile prédéterminé respectif, ainsi qu'
- un dispositif d'affichage (44) comprenant
- un dispositif de détection (30) pour détecter l'état de chargement de pile (32) du terminal d'utilisateur,
- une commande d'alimentation en énergie (28) pour désactiver les composants électriques (16, 18) des applications individuelles dans le cas d'un état de chargement de pile prédéterminé respectif,
- un afficheur (26) pour représenter l'état de chargement de pile (32) entier du terminal d'utilisateur (10),
- des moyens d'état de chargement (34) pour déterminer et afficher un état de chargement de pile spécifique d'une application (50a, 50b, 50c) pour au moins l'une des applications,
- des moyens de détermination du temps de marche restant (36) pour déterminer et afficher une durée résiduelle (54a, 54b, 54c) d'une application en fonction de l'état de chargement de pile spécifique de l'application (50a, 50b, 50c) et d'une consommation d'énergie des applications actives
et
- des moyens de réglage (40) pour définir ou changer la priorité d'une application pour une désactivation, **caractérisé en ce que** le dispositif d'affichage (44) comprend des moyens destinés à afficher l'utilisation de pile respective par une application.

5. Terminal d'utilisateur électronique et fonctionnant à piles (10) selon la revendication 4, **caractérisé en ce que** les moyens d'état de chargement (34) pour déterminer l'état de chargement de pile spécifique d'une application (50a, 50b, 50c) d'une application sont configurés pour une désactivation sur la base de l'état de chargement de pile (32) et d'une priorité prédéterminée de l'application.

6. Terminal d'utilisateur électronique et fonctionnant à piles (10) selon la revendication 4 ou la revendication 5, **caractérisé en ce que** des moyens de commutation (42) sont prévus pour activer ou désactiver au moins une application par l'utilisateur.

7. Terminal d'utilisateur électronique et fonctionnant à piles (10) selon l'une des revendications 4 à 6, **caractérisé en ce que** le terminal d'utilisateur (10) est un terminal mobile pour un réseau radio mobile.

8. Procédé de représentation d'un état de chargement de pile (32) d'un terminal d'utilisateur électronique et fonctionnant à piles (10), lequel est configuré pour une pluralité d'applications pour un utilisateur, et lequel comprend à cette fin une pluralité de composants électriques (16, 18) pour effectuer les applications et une pile (12) pour l'alimentation en énergie des composants électriques (16, 18), comprenant les étapes de procédé de:
- détecter l'état de chargement de pile (32) par moyen d'une unité de détection (30),
- désactiver les composants électriques (16, 18) des applications individuelles dans le cas d'un état de chargement de pile prédéterminé respectif par moyen d'une commande d'alimentation en énergie (28),
- représenter l'état de chargement de pile (32) sur un afficheur (26),
- déterminer et afficher un état de chargement de pile spécifique pour une application (50a, 50b, 50c) pour au moins l'une des applications par moyen des moyens d'état de chargement (34),
- déterminer et afficher une durée résiduelle (54a, 54b, 54c) d'une application en fonction de l'état de chargement de pile spécifique de l'application (50a, 50b, 50c) et d'une consommation d'énergie des applications actives par moyen des moyens de détermination du temps de marche restant (36),
- et prédéfinir ou changer la priorité d'une application par moyen des moyens de réglage (40), **caractérisé par** l'affichage d'une utilisation de pile respective (56a, 56b, 56c), qui est réalisée par une application.

9. Procédé selon la revendication 8, **caractérisé en ce que** pour déterminer l'état de chargement de pile spécifique pour une application (50a, 50b, 50c) d'une application on utilise l'état de chargement de pile (32) et une priorité prédéterminée de l'application pour une désactivation.

10. Procédé selon la revendication 8 ou la revendication 9, **caractérisé en ce qu'**une activation ou qu'une désactivation d'au moins une application par l'utilisateur est prévue.
